# FASCICULE DE BREVET EUROPEEN

(11) **EP 0 485 308 B1**
(45) Date de publication et mention de la délivrance du brevet: **10.05.1995**
(21) Numéro de dépôt: 91420386.4
(22) Date de dépôt: 29.10.1991
(51) Int. Cl.: H05K 7/20

(54) **Procédé de fabrication d'une carte électronique à drain thermique.**
Herstellungsverfahren einer elektronischen Karte mit Wärmeabführung.
Manufacturing process of an electronic card with a heat sink.

(30) Priorité: 09.11.1990 FR 9014016
(43) Date de publication de la demande: 13.05.1992
(73) Titulaire: SCHNEIDER ELECTRIC SA, 92100 Boulogne Billancourt (FR)
(72) Inventeur: Besanger, Michel, F-38050 Grenoble Cédex (FR)
(74) Mandataire: Ritzenthaler, Jacques

(56) Documents cités:
- EP-A- 0 340 520
- DE-A- 1 913 679
- US-A- 4 315 300
- US-A- 4 603 374
- US-A- 4 768 286

## Description

L'invention est relative à un procédé de fabrication d'une carte électronique, portant un circuit imprimé et des composants électroniques répartis sur l'une et/ou l'autre des faces de la carte, cette dernière étant munie d'un drain thermique.

Les composants électroniques ne supportent pas des températures élevées, par exemple supérieures à 150°, et ces températures sont rapidement atteintes si la chaleur engendrée par les composants n'est pas évacuée. Le problème de refroidissement des composants est amplifié par le rassemblement de nombreux composants sur des cartes de circuits imprimés en matière isolante, et par le regroupement de ces cartes dans des coffrets souvent étanches et disposés en des emplacements mal aérés. La solution usuelle est un refroidissement par convection du coffret ou directement des cartes, en créant une circulation forcée d'air ou d'un liquide d'évacuation des calories. Ces sytèmes nécessitent un ventilateur ou une pompe dont la fiabilité n'est pas absolue et qui présente des risques de pannes et de fuites, ainsi que d'autres nuisances.

Un autre système connu de refroidissement de cartes fait usage d'un drain thermique incorporé dans la carte. Ce drain thermique en forme de plaque métallique pose de sérieux problèmes d'isolation électrique, et de bonnes liaisons thermiques avec les boîtiers des composants qui doivent être refroidis. Un tel système est compliqué et d'une faible efficacité.

Le document DE-A-1 913 679 décrit un drain thermique en forme de plaque métallique disposée parallèlement à la carte, et revêtue d'une couche plastique ayant une conduction thermique supérieure à celle de l'air. En rapprochant la plaque et la carte, les composants pénètrent partiellement dans la couche plastique, créant ainsi un pont thermique entre chaque composant et la plaque métallique.

Le document EP-0 340 520 décrit un autre mode de réalisation d'un tel drain thermique, par création d'un pont thermique entre chaque composant et la plaque métallique.

La présente invention a pour but de permettre la réalisation d'une carte équipée d'un dispositif statique de refroidissement particulièrement simple et efficace.

A cet effet, le procédé selon l'invention est décrit à la revendication 1.

En faisant le vide dans l'enveloppe, celle-ci vient se plaquer sur la carte et les composants en épousant étroitement leurs contours. Ce placage est renforcé lors de la coulée du silicone liquide dans un moule préalablement posé sur la carte. Il est particulièrement simple de disposer la carte horizontalement et de placer sur cette carte un moule en forme de cadre, encerclant les composants. De cette façon, seule la face de la carte portant les composants est revêtue de silicone, et la face libre de cette couche de silicone est parfaitement plane et horizontale, assurant un bon contact sur toute la surface avec la plaque de drain thermique qui est avantageusement mise en place après enlèvement du cadre de moulage. Il suffit par la suite, d'enlever le surplus de film isolant, en l'occurrence du film de polypropylène pour donner accès aux connexions électriques de la carte. La plaque de drain thermique est avantageusement en aluminium ou cuivre, ou en tout autre métal bon conducteur de la chaleur, et ses dimensions, notamment son épaisseur sont calculées pour assurer une conduction suffisante.

Les cartes électroniques ainsi que les composants électroniques, sont du type standard, de simple format ou de double format, et aucune précaution particulière n'est nécessaire, le film isolant de polypropylène assurant une séparation mécanique et électrique entre la carte et les drains thermiques constitués par la pâte et la plaque métallique.

La plaque métallique formant le drain thermique est éloignée de la carte de circuit imprimé, où sont situées les connexions électriques, et le contact thermique avec les composants électroniques de tailles variées est assuré par la pâte d'enrobage remplissant l'espace entre les composants et la plaque métallique. Les plaques métalliques sont elles- mêmes en bon contact thermique avec la paroi du coffret, celui-ci ayant notamment des rainures de guidage recevant les bords de la plaque. On comprend que la chaleur engendrée par les composants est transférée à travers la pâte conductrice vers la plaque métallique et le coffret. La pâte épouse le contour des boîtiers des composants et assurent ainsi un contact avec l'ensemble de la surface de ces boîtiers.

Le film plastique, par exemple constitué par un film en polypropylène de faible épaisseur, assure d'une part une isolation électrique entre la pâte et les circuits électriques portés par la carte, et d'autre part une séparation mécanique permettant une séparation ou un enlèvement de la pâte des composants pour accèder à ces derniers en cas de réparation ou d'autre intervention sur la carte. Cet enlèvement de la pâte est facilité par sa plasticité.

La pâte est avantageusement constituée d'une résine silicone chargée de nitrure d'aluminium ou d'oxyde d'aluminium, le pourcentage en poids du nitrure d'aluminium étant compris entre 10 et 80%, et de préférence entre 50 et 70%. La résine silicone est mise en place à l'état liquide et elle présente le grand avantage d'une réticulation à froid qui évite tout échauffement des composants et de la carte. Après réticulation, la résine conserve une plasticité suffisante tout en assurant une bonne conduction thermique.

La même plaque de drain thermique peut porter plusieurs cartes, celles-ci étant réparties sur une seule face de la plaque ou sur les deux faces, le nombre étant limité par les capacités de drainage thermique de la plaque. Les deux faces de la carte peuvent être traitées, en l'occurrence être associées chacune à une plaque de drain thermique.

La plaque de drain thermique assure avantageusement le support mécanique de la carte, cette dernière étant simplement reliée par un connecteur électrique à la partie fixe du coffret.

D'autres avantages et caractéristiques ressortiront plus clairement de la description qui va suivre, d'un mode de mise en oeuvre de l'invention, donné à titre d'exemple non limitatif et représentés aux dessins annexés dans lesquels:
La figure 1 est une vue schématique en coupe, d'un coffret électronique montré pour faciliter la compréhension de l'invention ;

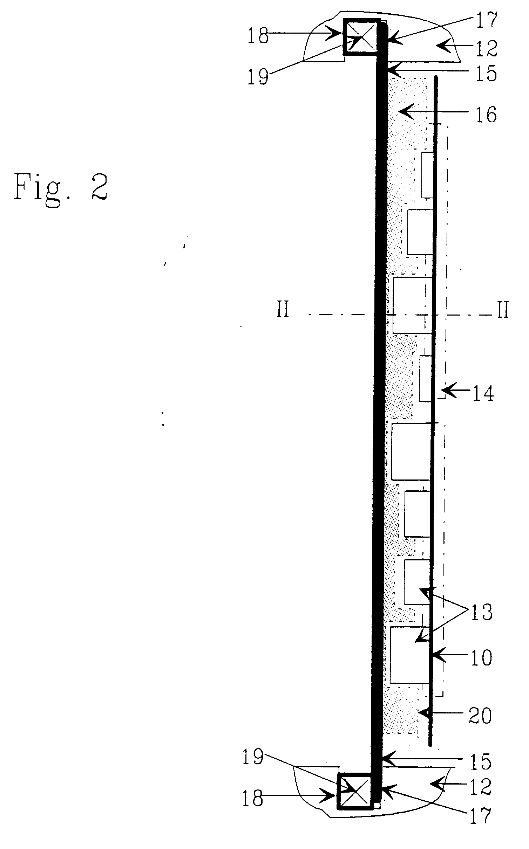

La figure 2 est une vue à échelle agrandie d'une partie de la figure 1;

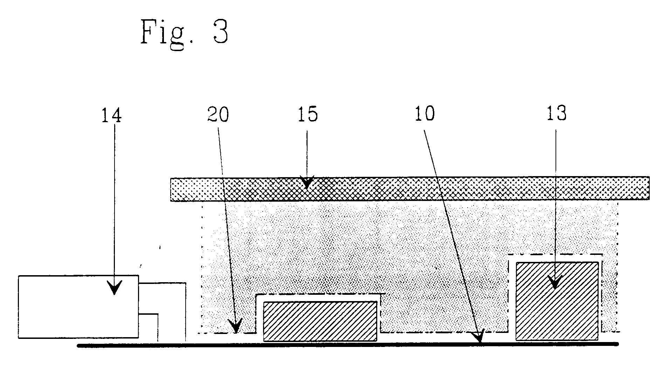

La figure 3 est une coupe suivant la ligne II-II de la figure 2 ;
Les figures 4 à 6 montrent les différentes étapes du procédé selon l'invention pour la mise en place du drain thermique sur la carte électronique.

Sur les figures, plusieurs cartes électroniques 10, sont logées dans un coffret 11 de forme générale parallélépipèdique et à parois métalliques 12. Chaque carte 10 en un matériau isolant porte un circuit imprimé (non représenté) et des composants 13 connectés à ce circuit imprimé. Ces cartes 10 d'un type standard à simple ou double format comportent sur l'un de leurs bords un connecteur électrique 14 en forme de bornier, bien connu des spécialistes. A chaque carte 10 est associée une plaque métallique 15, notamment en aluminium qui s'étend parallèlement à la carte 10, de manière à encadrer avec cette dernière les composants 13. L'intervalle entre la carte 10 et la plaque 15 est rempli d'une pâte 16 ayant une conduction thermique supérieure à celle de l'air. La pâte 16 et la plaque 15 constituent des drains thermiques d'évacuation par conduction de la chaleur engendrée par les composants 13. Deux bords opposés 17 de la plaque 15 font saillie de la carte 10 et sont engagés dans des rainures en forme de glissière 18 ménagées dans la paroi 12 du coffret 11. Un connecteur thermique 19, engagé dans la rainure 18, maintient un bon contact mécanique et thermique entre les bords 17 et la paroi de la rainure 18. La pâte 16 est avantageusement une résine silicone coulée à froid et comportant une charge d'oxyde d'aluminium hydraté ou de nitrure d'aluminium, le pourcentage en poids du nitrure d'aluminium étant compris entre 10 et 80%, et de préférence entre 50 et 70%. Le pourcentage d'oxyde d'aluminium hydraté est compris entre 50 et 80%. Le contact direct entre la pâte 16 et les composants 13 ou la carte 10, est empêché par interposition d'un film plastique souple 20 plaqué sur les composants 13 et la carte 10. Ce film plastique, notamment en polypropylène, d'une épaisseur voisine de quelques microns, renforce la rigidité diélectrique et facilite l'enlèvement de la pâte 16 pour une intervention sur la carte 10 de la manière décrite par la suite.

La quasi-totalité de la surface des boîtiers des composants 13 est en contact direct avec la pâte de drain thermique 16, la présence du film de polypropylène 20 étant négligeable. La chaleur engendrée par les composants 13 est conduite par la pâte 16 et la plaque 15 vers la paroi 12 du coffret 11, et évite ainsi un échauffement excessif des composants 13 et de la carte 10. Ce système de refroidissement est entièrement statique et fiable.

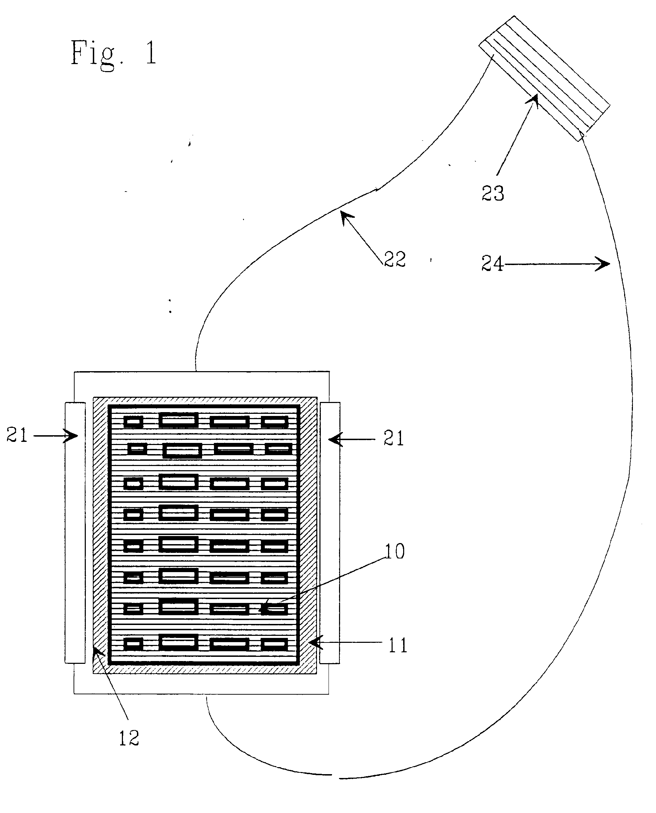

La paroi 12 du coffret 11 peut constituer un radiateur efficace si ce coffret est disposé dans une température ambiante suffisamment basse. Il est néanmoins souvent nécessaire de refroidir ce coffret 11, et en se référant plus particulièrement à la figure 1, on voit qu'à deux parois 12 du coffret 11 sont accolées des plaques collectrices 21 en bon contact de la paroi 12. Il est clair que toutes les parois peuvent comporter des plaques de refroidissement. Les plaques collectrices 21 contiennent des conduits de circulation d'eau (non représentés) reliés à leur partie supérieure à une canalisation 22 de circulation de l'eau vers une source froide ou un radiateur 23. La partie basse des plaques collectrices 21 est reliée d'une manière analogue par une canalisation 24 au radiateur 23 qui se situe en un emplacement plus élevé et dans une zone relativement froide par rapport au coffret 11. On voit que le radiateur 23, les canalisations 22, 24 et les plaques collectrices 21 constituent un système de refroidissement par thermosiphon à simple phase qui permet d'évacuer les calories du coffret 11 vers le milieu ambiant. Ce système est particulièrement simple et ne nécessite pas une pompe de circulation, tout contact entre le circuit 21 et la partie électrique étant exclu.

La combinaison du refroidissement par conduction de la chaleur par les drains thermiques à pâte 16 et à plaque métallique 15 vers le coffret 11 et le système de refroidissement du coffret par convection, par thermosiphon répond à quasiment tous les besoins. Les plaques 15 peuvent consistuer les supports des cartes 10, et la liaison constituée par la pâte 16 peut éventuellement être renforcée par tout moyen approprié, notamment par des boulons, lorsque cette liaison s'avère insuffisante. La disposition des cartes 10 dans le coffret 11 est quelconque et il est possible d'associer à la plaque métallique 15 une deuxième carte électronique 10 sur la face opposée de cette plaque. Il est également possible de monter plusieurs cartes électroniques 10 sur une même plaque 15, en les disposant les unes à côté des autres, ces cartes 10 étant soit d'un format réduit, soit associées à une plaque 15 de plus grande dimension.

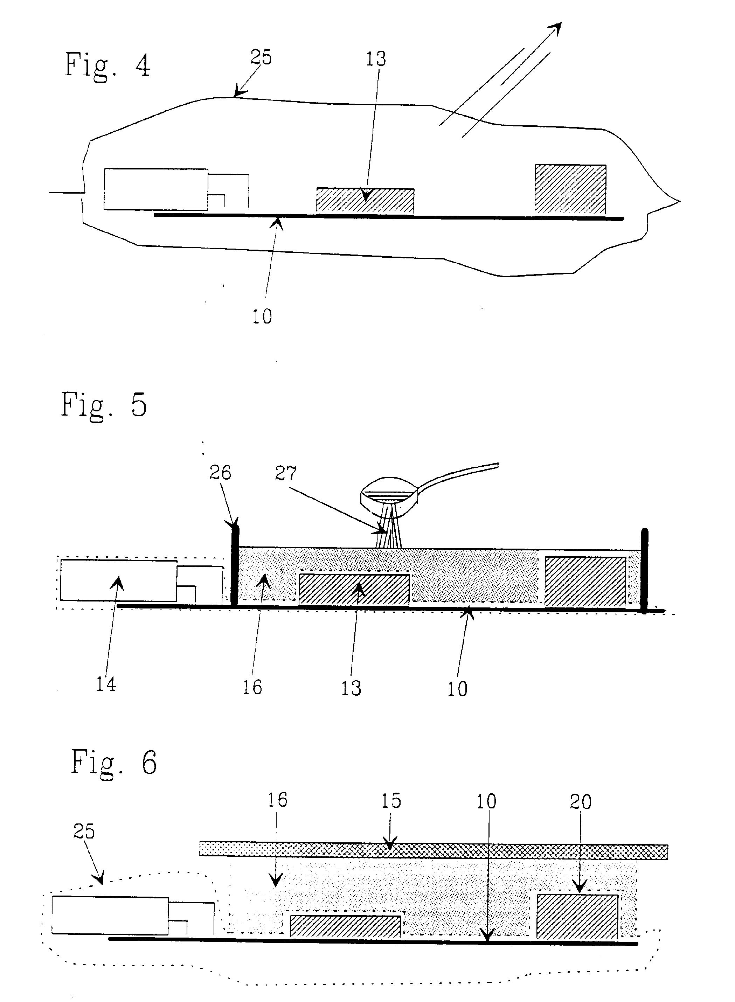

L'association de la plaque de drain thermique 15 à la carte électronique 10 est avantageusement réalisée de la manière suivante, illustrée par les figures 4 à 6.

La carte 10 standard avec ces composants 13 est introduite dans un sachet ou enveloppe 25 constituée par un film souple, notamment en polypropylène. Après fermeture de cette enveloppe, celle-ci est mise sous vide, de manière à plaquer le film plastique 25 sur les composants 13 et la carte 10. Cette carte 10 avec son film de polypropylène 25 est posée sur un support horizontal et sur sa face opposée est disposé un cadre 26 qui encadre l'ensemble des composants 13. Il suffit de couler la résine liquide 27 dans le moule 26 et de remplir ce dernier suffisamment pour recouvrir tous les composants 13. La coulée s'effectue à froid et la résine, en l'occurrence de silicone est du type à réticulation à froid, permettant d'obtenir après un temps prédéterminé, par exemple d'un ou de deux jours, une pâte 16 élastique qui épouse entièrement les contours des composants 13 et de la carte 10. Le bornier connecteur 14 est avantageusement laissé à l'extérieur du cadre moule 26, de manière à donner accès à ce bornier après enlèvement de la partie du film polypropylène 25 en surplus. Après enlèvement du moule 26 et de cette partie en surplus du film de polypropylène 25, il suffit de plaquer la plaque de drain thermique 15 sur la face libre de la pâte 16 pour obtenir un ensemble de carte associée à un drain thermique. La pâte 16 reste suffisamment souple pour pouvoir le cas échéant enlever cette pâte de la carte 10 et des composants 13 après déboulonnage de la carte 10 et du drain métallique 15, la séparation étant facilitée par la présence du film isolant de polypropylène 20. D'autres procédés de coulée sont utilisables, notamment par injection, et d'autres résines conservant après réticulation une certaine plasticité ainsi que d'autres charges, sont utilisables.

L'invention est bien entendu nullement limitée au mode de mise en oeuvre plus particulièrement représenté.

## Revendications

1. Procédé de fabrication d'une carte de circuit imprimé portant des composants électroniques (13) et associée à un drain thermique (15), caractérisé en ce que la carte (10) avec les composants (13) est glissée dans une enveloppe (25) constituée par un film plastique, que le film plastique est ensuite plaqué sur les composants en faisant le vide dans l'enveloppe, qu'une pâte (16) bonne conductrice de la chaleur est moulée sur le film plastique et qu'une plaque métallique (15) est finalement appliquée sur ladite pâte (16) pour constituer ledit drain thermique.

2. Procédé selon la revendication 1, caractérisé en ce qu'un moule (26) est disposé sur la carte et que ladite pâte (16) à réticulation à froid est coulée sous forme liquide (27) dans le moule, lequel est enlevé après la réticulation.

3. Procédé selon la revendication 1 ou 2, caractérisé en ce que la partie du film plastique, qui n'est pas enrobée par ladite pâte (16), est enlevée pour donner accès au connecteur électrique (14) de la carte.

## Patentansprüche

1. Verfahren zur Herstellung einer Leiterplatte mit gedruckten Schaltkreisen und elektronischen Bauelementen (13), die mit einem Kühlkörper (15) ausgerüstet ist, dadurch gekennzeichnet, daß die mit den Bauelementen (13) bestückte Leiterplatte (10) in eine aus einer Kunststoffolie bestehende Umhüllung (25) eingeführt wird und die Kunststoffolie sich durch Evakuierung der Umhüllung anschließend um die Bauelemente legt, daß eine Paste (16) mit guter Wärmeleitfähigkeit auf die Kunststoffolie gegossen und abschließend eine Metallplatte (15) zur Bildung des genannten Kühlkörpers auf der genannten Paste (16) angebracht wird.

2. Verfahren nach Anspruch 1, dadurch gekennzeichnet, daß eine Form (26) auf die Leiterplatte aufgesetzt, die genannte kaltvernetzende Paste (16) in flüssigem Zustand (27) in die Form gegossen und diese nach der Vernetzung entfernt wird.

3. Verfahren nach Anspruch 1 oder 2, dadurch gekennzeichnet, daß der nicht von der genannten Paste (16) bedeckte Teil der Kunststofffolie entfernt wird, um den Zugang zum Steckverbinder (14) der Leiterplatte zu ermöglichen.

## Claims

1. A manufacturing process of a printed circuit card supporting electronic components (13) and associated with a heat sink (15), characterized in that the card (10) with the components (13) is slid into an envelope (25) formed by a plastic film, that the plastic film is then pressed onto the components by creating a vacuum in the envelope, that a good heat conducting pulp (16) is moulded onto the plastic film and that a metal plate (15) is finally applied to said pulp (16) to constitute said heat sink.

2. The process according to claim 1, characterized in that a mould (26) is placed on the card and that said cold reticulation pulp (16) is poured in liquid form (27) into the mould, which is removed after reticulation.

3. The process according to claim 1 or 2, characterized in that the part of the plastic film which is not covered by said pulp (16) is removed to give access to the electrical connector (14) of the card.
